# EUROPEAN PATENT APPLICATION

(11) **EP 4 839 043 A1**
(43) Date of publication of application: **11.11.2026**
(21) Application number: 24923742.1
(22) Date of filing: 17.12.2024
(51) Int. Cl.: H05K 13/02, B65D 85/86

(54) **STORAGE CASE**

(30) Priority: 09.02.2024 JP 2024019013
(71) Applicant: Murata Manufacturing Co., Ltd., Nagaokakyo-shi, Kyoto 617-8555 (JP)
(72) Inventor: NAKAGAWA Kiyoyuki, Nagaokakyo-shi, Kyoto 617-8555 (JP)
(74) Representative: Stöckeler, Ferdinand
(86) International application number: PCT/JP2024/044614
(87) International publication number: WO 2025/169610

(57) **Abstract**

Provided is a storage case that can suppress clogging of a component take-out port with components accommodated thereinside or staying of components dropped from the component take-out port below the component take-out port. A storage case 1 comprises: a case body 2 having therein an accommodation space 6 capable of accommodating components 5; a component take-out port 18 that is provided to the case body 2 and has an inside opening 19 opened to the accommodation space 6 side and an outside opening 20 opened to the outside of the case body 2; a first slope 21 that is provided in the accommodation space 6 and extends toward the inside opening 19; and a second slope 24 that extends from the inside opening 19 toward the outside opening 20 so that the components 5 can be guided from the inside opening 19 to the outside opening 20.

## Description

### TECHNICAL FIELD

The present invention relates to a storage case for electronic components.

### BACKGROUND ART

Conventionally, when mounting electronic components on a substrate, a mounting device is used to mount the electronic components at predetermined positions on the substrate. Such a mounting device requires electronic components to be supplied individually. For example, Patent Document 1: Japanese Unexamined Patent Application, Publication No. 2009-295618 discloses a case that collectively accommodates a plurality of electronic components in a loose state, and allows the electronic components to drop by their own weight from an outlet at the bottom to a feeder.

### Citation List

### Patent Documents

Patent Document 1: Japanese Unexamined Patent Application Publication No. 2009-295618

### DISCLOSURE OF THE INVENTION

### Problems to be Solved by the Invention

In this type of case, depending on the configuration of the feeder, in addition to a configuration in which electronic components are dropped from an outlet provided at the bottom of the case, there is a configuration in which electronic components are allowed to drop by their own weight from an outlet provided in a side wall portion of the case. In such a case where the outlet is provided in the side wall portion, when the electronic components are allowed to drop by their own weight from the outlet by vibrating with the feeder, there is a risk that the electronic components may become jammed in the outlet, or that electronic components that have dropped from the outlet may remain below the outlet. When such problems occur, it is not possible to smoothly supply electronic components to the mounting device.

It is an object of the present invention to provide a storage case capable of suppressing components accommodated therein from becoming jammed in a component outlet and components that have dropped from the component outlet from remaining below the component outlet.

### Means for Solving the Problems

A storage case according to an embodiment of the present invention includes: a case main body including an accommodation space therein capable of accommodating components; a component outlet provided in the case main body and including an inner opening that opens to the accommodation space and an outer opening that opens to an outer side of the case main body; a first sloped surface provided in the accommodation space and extending toward the inner opening; and a second sloped surface extending from the inner opening toward the outer opening in order to guide the components from the inner opening to the outer opening.

### Effects of the Invention

According to an embodiment of the present invention, it is possible to provide a storage case capable of suppressing components accommodated therein from becoming jammed in a component outlet and components that have dropped from the component outlet from remaining below the component outlet.

### BRIEF DESCRIPTION OF THE DRAWINGS

FIG. 1 is a side view showing the interior of a storage case according to Embodiment 1 of the present invention.
FIG. 2 is a front view showing the storage case according to Embodiment 1 of the present invention.
FIG. 3 is a bottom view showing the storage case according to Embodiment 1 of the present invention.
FIG. 4 is a schematic perspective view showing an enlarged portion of the storage case according to Embodiment 1 of the present invention.
FIG. 5 is a side view showing a portion of the interior of the storage case according to Embodiment 1 of the present invention, showing a state in which the component outlet of the storage case is closed by a cover member.
FIG. 6 is a side view showing a portion of the interior of the storage case according to Embodiment 1 of the present invention, showing a state in which the component outlet of the storage case is opened.
FIG. 7 is a schematic perspective view showing an enlarged portion of a storage case according to Embodiment 2 of the present invention.
FIG. 8 is a schematic perspective view showing an enlarged portion of a storage case according to Embodiment 3 of the present invention.

### PREFERRED MODE FOR CARRYING OUT THE INVENTION

Hereinafter, specific embodiments of the present invention are described in detail with reference to the drawings.

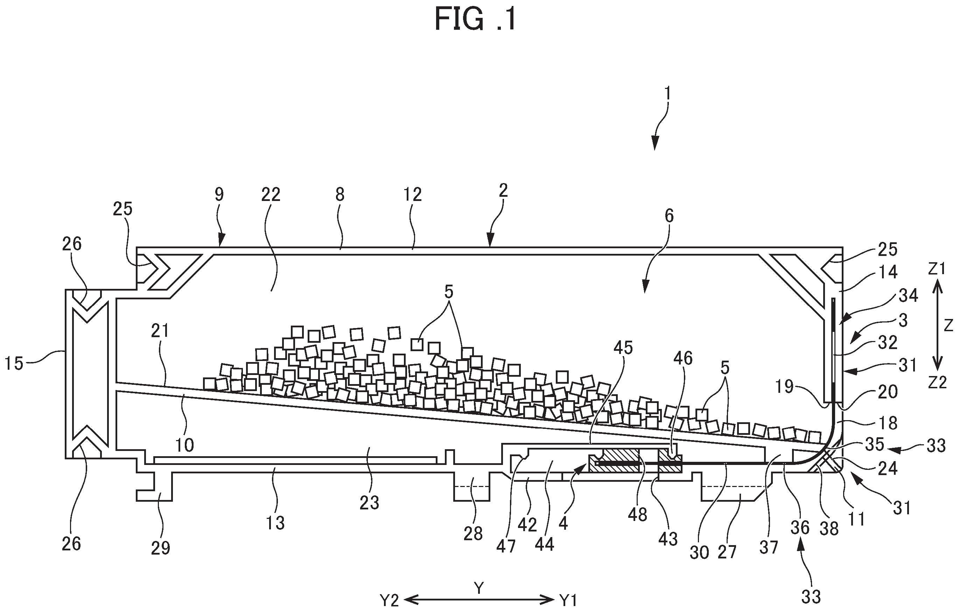

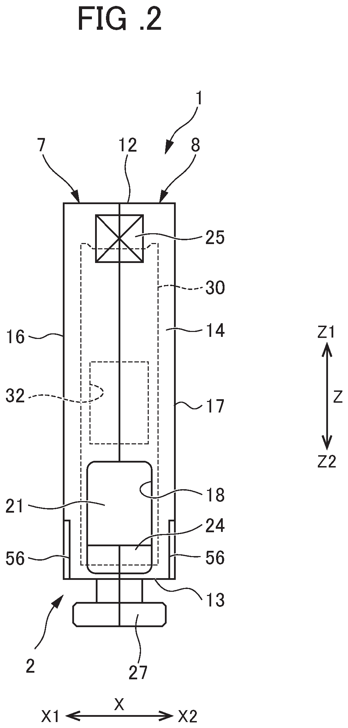

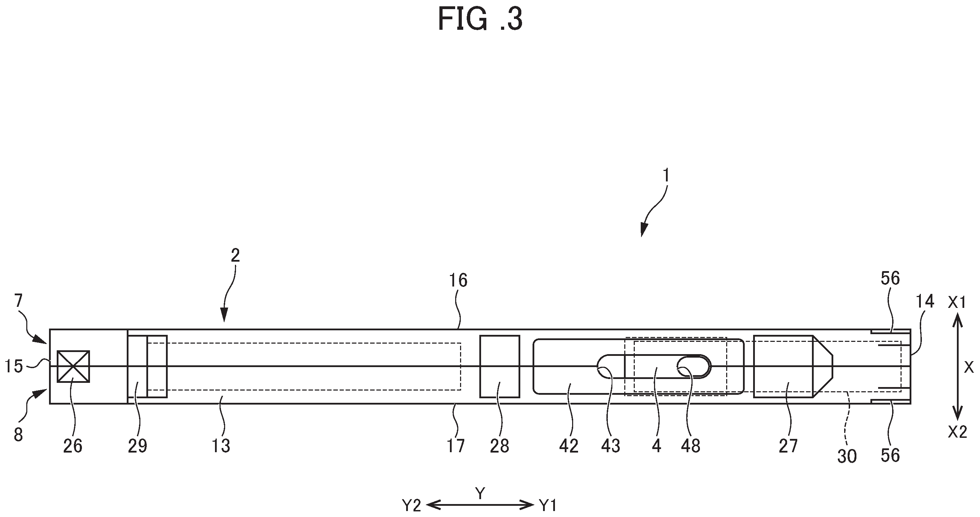

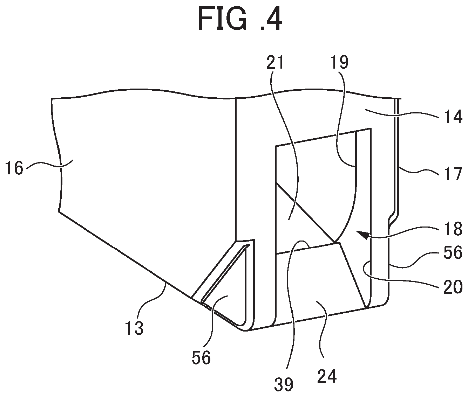

FIG. 1 is a side view showing the interior of a storage case according to Embodiment 1 of the present invention. FIG. 2 is a front view showing the storage case according to Embodiment 1 of the present invention. FIG. 3 is a bottom view showing the storage case according to Embodiment 1 of the present invention. FIG. 4 is a schematic perspective view showing an enlarged portion of the storage case according to Embodiment 1 of the present invention. The storage case 1 of the present Embodiment 1 includes a case main body 2, a shutter mechanism 3, and a slide member 4.

Arrow X, arrow Y, and arrow Z shown in any of FIGS. 1, 2, and 3 indicate the left-right direction, the forward-backward direction, and the upward-downward direction, respectively, of the storage case 1 in a state set in a feeder (not shown) that applies vibration to the storage case 1. In the left-right direction X, the left side is indicated by X1 and the right side is indicated by X2; in the forward-backward direction Y, the front side is indicated by Y1 and the rear side is indicated by Y2; and in the upward-downward direction Z, the upper side is indicated by Z1 and the lower side is indicated by Z2. In FIGS. 4 through 8 as well, any of the left-right direction X, the forward-backward direction Y, and the upward-downward direction Z is similarly applied. Each of the left-right direction, the forward-backward direction, and the upward-downward direction in the following description is based on the directions indicated by the above arrows.

The case main body 2 has a substantially rectangular shape in a side view with the forward-backward direction Y as the longitudinal direction, and is a flat box shape with a thin thickness in the left-right direction X. The case main body 2 is hollow and includes an accommodation space 6 capable of accommodating components 5 therein. In the illustrated example, the case main body 2 includes a first member 7 located on the left side X1 and a second member 8 located on the right side X2. The first member 7 has a box shape that is substantially rectangular in a side view with the forward-backward direction Y as the longitudinal direction, and is open on the right side X2. The second member 8 has a box shape that is substantially rectangular in a side view with the forward-backward direction Y as the longitudinal direction, and is open on the left side X1. The case main body 2 is assembled by joining the first member 7 and the second member 8 in a state in which the right end portion of the first member 7 and the left end portion of the second member 8 are in contact with each other. As a result, the accommodation space 6 capable of accommodating a plurality of components 5 is provided inside the case main body 2.

The plurality of components 5 are accommodated in the accommodation space 6 in a loose state. The components 5 accommodated in the accommodation space 6 are, for example, electronic components. The electronic component has a substantially rectangular parallelepiped shape. The length of the electronic component in the longitudinal direction is 1.2 mm or less. The electronic component is, for example, a capacitor or an inductor, but is not limited thereto.

FIG. 1 shows the interior of the second member 8 in a state in which the first member 7 is omitted from the case main body 2. In the following description, the first member 7 and the second member 8 are not described individually unless necessary, and the configuration in a state in which the first member 7 and the second member 8 are joined will be described. The case main body 2 includes an outer wall portion 9, a first sloped portion 10, and a second sloped portion 11.

The outer wall portion 9 surrounding the accommodation space 6 includes an upper wall portion 12, a bottom wall portion 13, a front wall portion 14, a rear wall portion 15, a left wall portion 16, and a right wall portion 17. The upper wall portion 12 is located on the upper side of the storage case 1. The upper wall portion 12 has a substantially plate shape, and extends in the forward-backward direction Y with its plate surface facing the upward-downward direction Z. The bottom wall portion 13 is located on the lower side of the storage case 1. The bottom wall portion 13 has a substantially plate shape, and extends in the forward-backward direction Y with its plate surface facing the upward-downward direction Z. The front wall portion 14 is located on the front side of the storage case 1. The front wall portion 14 has a substantially plate shape, and extends in the upward-downward direction Z with its plate surface facing the forward-backward direction Y. The rear wall portion 15 is located on the rear side of the storage case 1. The rear wall portion 15 has a substantially plate shape, and extends in the upward-downward direction Z with its plate surface facing the forward-backward direction Y. The left wall portion 16 is located on the left side of the storage case 1, adjacent to the first member 7. The left wall portion 16 has a substantially plate shape, and extends in the upward-downward direction Z with its plate surface facing the left-right direction X. The right wall portion 17 is located on the right side of the storage case 1, adjacent to the second member 8. The right wall portion 17 has a substantially plate shape, and extends in the upward-downward direction Z with its plate surface facing the left-right direction X.

The outer wall portion 9 of the case main body 2 is provided with a component outlet 18 for discharging the components 5 in the accommodation space 6 to the outside of the case main body 2. In the present Embodiment 1, the component outlet 18 is provided in the lower portion of the front wall portion 14 of the case main body 2. The component outlet 18 has a substantially quadrangular shape in a front view and penetrates the case main body 2 in the forward-backward direction Y. The component outlet 18 includes an inner opening 19 and an outer opening 20. The inner opening 19 is provided adjacent to the accommodation space 6 relative to the outer opening 20. The outer opening 20 is provided on an outer side of the case main body 2 relative to the inner opening 19. The inner opening 19 opens to the accommodation space 6 and the outer opening 20 opens to the outer side of the case main body 2. The inner opening 19 is provided on the inner surface of the front wall portion 14 of the outer wall portion 9. In the illustrated example, the rear end of the lower end portion of the inner opening 19 is curved toward the rear side Y2 in a side view. The distance between the lower edge of the inner opening 19 and the lower surface of the bottom wall portion 13 of the case main body 2 is, for example, 6 mm. The outer opening 20 is provided on the outer surface of the front wall portion 14 of the outer wall portion 9. The lower edge portion of the outer opening 20 is located at the lower corner portion located on the front side of the case main body 2. The distance between the lower edge of the outer opening 20 and the lower surface of the bottom wall portion 13 of the case main body 2 is, for example, 3 mm. In addition, the component outlet 18 is not limited to a substantially quadrangular shape in a front view, and may be, for example, in a substantially circular shape in a front view or in a substantially elliptical shape in a front view.

The first sloped portion 10 that vertically partitions the accommodation space 6 is provided between the left wall portion 16 and the right wall portion 17 in the accommodation space 6. The first sloped portion 10 has a substantially plate shape, and extends in the forward-backward direction Y with its plate surface facing the upward-downward direction Z. The first sloped portion 10 extends from the rear wall portion 15, which is on the opposite side from the front wall portion 14 on which the component outlet 18 is provided, toward the inner opening 19. The first sloped portion 10 is sloped with a downward slope from the rear wall portion 15 toward the inner opening 19. That is, the rear end portion of the first sloped portion 10 is located at the uppermost position, and the front end portion of the first sloped portion 10 is located at the lowermost position. The upper plate surface of the first sloped portion 10 having such a configuration refers to a first sloped surface 21. Therefore, the first sloped surface 21 extends in the accommodation space 6 so as to aim at the front wall portion 14 located on the front side of the first sloped surface 21. Specifically, the first sloped surface 21 is provided in the accommodation space 6 and extends toward the inner opening 19. In the illustrated example, since the front end portion of the first sloped portion 10 extends to the lower edge portion of the inner opening 19, the first sloped surface 21 extends toward the lower edge portion of the inner opening 19.

As described above, the first sloped portion 10 extends from the rear wall portion 15 toward the front wall portion 14. Therefore, the accommodation space 6 is divided by the first sloped portion 10 into an upper space 22 on the upper side in which the components 5 are accommodated, and a lower space 23 located below the upper space 22. The inner opening 19 of the component outlet 18 opens into the upper space 22. Since the first sloped surface 21 is sloped so as to allow the plurality of components 5 accommodated in the accommodation space 6 to slide down, the plurality of components 5 accommodated in the upper space 22 can be guided to the component outlet 18 via the first sloped surface 21 by vibrating the case main body 2.

The second sloped portion 11 is provided between the left wall portion 16 and the right wall portion 17 on the outside of the accommodation space 6. The second sloped portion 11 has a substantially plate shape, and extends in the forward-backward direction Y with its plate surface facing the upward-downward direction Z. The second sloped portion 11 extends so as to aim at the outer surface of the front wall portion 14 located on the front side of the first sloped portion 10. Specifically, the second sloped portion 11 extends from the inner opening 19 toward the outer opening 20. The second sloped portion 11 is sloped with a downward slope from the inner opening 19 toward the outer opening 20. That is, the rear end portion of the second sloped portion 11 is located at the uppermost position, and the front end portion of the second sloped portion 11 is located at the lowermost position. The upper plate surface of the second sloped portion 11 having such a configuration refers to the second sloped surface 24. Therefore, the second sloped surface 24 extends from the inner opening 19 toward the outer opening 20. In the illustrated example, the second sloped surface 24 is a portion of the inner surface of the component outlet 18, which is a through hole. Specifically, the front end portion of the second sloped portion 11 corresponds to the lower edge portion of the outer opening 20, and the rear end portion of the second sloped portion 11 corresponds to the lower edge portion of the inner opening 19. Therefore, the second sloped surface 24 extends from the lower edge portion of the inner opening 19 toward the lower edge portion of the outer opening 20. At this time, the second sloped surface 24 extends from the inner opening 19 to the outer surface of the outer wall portion 9. Specifically, the second sloped surface 24 extends to the outer surface of the corner portion between the front wall portion 14 and the bottom wall portion 13.

As described above, the plurality of components 5 accommodated in the accommodation space 6 are guided to the inner opening 19 of the component outlet 18 via the first sloped surface 21. The second sloped surface 24 is sloped so that the components 5 guided to the inner opening 19 by the first sloped surface 21 are able to slide down, and thus, by vibrating the case main body 2, it is possible to guide the components 5 from the inner opening 19 to the outer opening 20. The components 5 guided to the outer opening 20 are discharged to the outside of the case main body 2 via the outer opening 20.

The second sloped surface 24 is either planar, curved, or includes a plurality of planes having different slope angles. In the present Embodiment 1, the second sloped surface 24 is planar. In the present Embodiment 1, the second sloped surface 24 forms an angle of 45° with respect to the horizontal plane. The second sloped surface 24 is not limited to forming an angle of 45° with respect to the horizontal plane, and preferably forms an angle of 40° or more and 90° or less with respect to the horizontal plane. In contrast, the first sloped surface 21 forms an angle of 5° with respect to the horizontal plane. The first sloped surface 21 is not limited to forming an angle of 5° with respect to the horizontal plane, and preferably forms an angle of 3° or more and 10° or less with respect to the horizontal plane. In this way, since the slope angle of the second sloped surface 24 with respect to the horizontal plane is greater than the slope angle of the first sloped surface 21 with respect to the horizontal plane, the second sloped surface 24 is sloped more greatly than the first sloped surface 21.

The second sloped surface 24 is in a state in which sliding of the components 5 is not impeded by grooves or scratches generated when the storage case 1 is formed. In the present Embodiment 1, the surface roughness Ra of the second sloped surface 24 is 2.0 µm. The surface roughness Ra of the second sloped surface 24 is not limited to 2.0 µm, and is preferably 0.5 µm or more and 2.0 µm or less. The surface roughness Ra of the first sloped surface 21 is, for example, 2.0 µm. In the present Embodiment 1, the surface resistance value of the second sloped surface 24 is not particularly limited, but is preferably 10⁹ to 10¹³ Ω/sq.

The case main body 2 includes upper grip portions 25 and rear grip portions 26. The upper grip portions 25 are provided at both front and rear end portions on the upper side of the case main body 2. The upper grip portion 25 located on the front side has a recessed shape recessed toward the rear side Y2, and the upper grip portion 25 located on the rear side has a recessed shape recessed toward the front side Y1. The rear grip portions 26 are provided at both upper and lower end portions on the rear side of the case main body 2. The rear grip portion 26 located on the upper side has a recessed shape recessed toward the lower side Z2, and the rear grip portion 26 located on the lower side has a recessed shape recessed toward the upper side Z1. The upper grip portions 25 and the rear grip portions 26 are gripped by, for example, a robot hand when the storage case 1 is transported by the robot hand.

The case main body 2 includes a plurality of claw portions for detachably installing the storage case 1 on a feeder that vibrates the storage case 1. In the present Embodiment 1, a first claw portion 27, a second claw portion 28, and a third claw portion 29 are provided on the bottom wall portion 13 of the case main body 2 at intervals in the forward-backward direction Y. The first claw portion 27, the second claw portion 28, and the third claw portion 29 are integrally formed with the case main body 2. The first claw portion 27 and the second claw portion 28 are each provided with a T-shaped slot having an inverted T-shape in a front-view longitudinal cross section. The third claw portion 29 has a substantially L-shaped plate shape in a side view, and extends from the bottom wall portion 13 of the case main body 2 toward the lower side Z2, and then extends toward the rear side Y2.

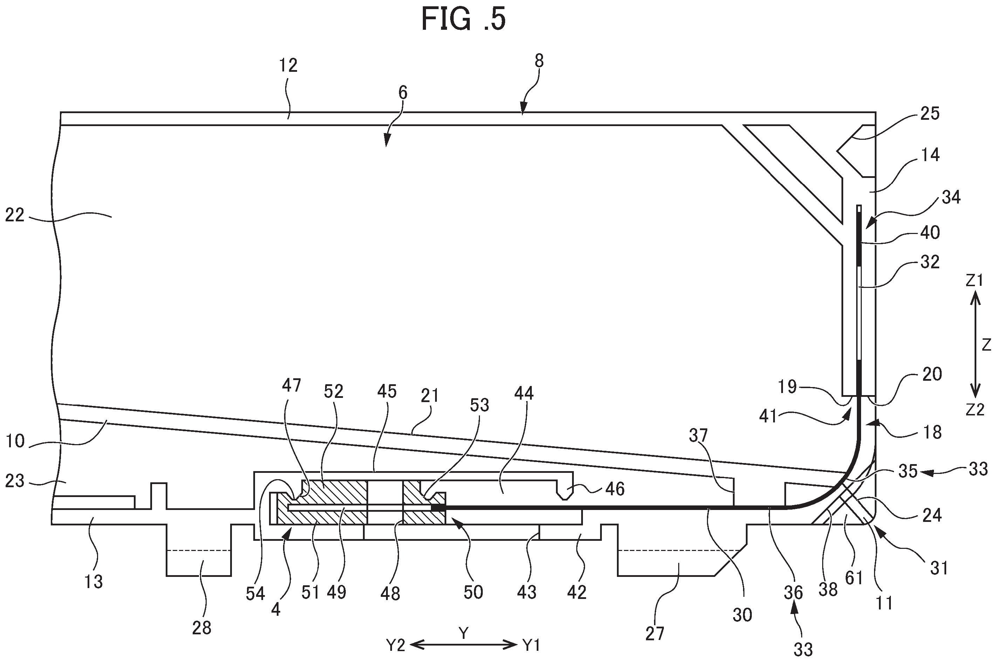

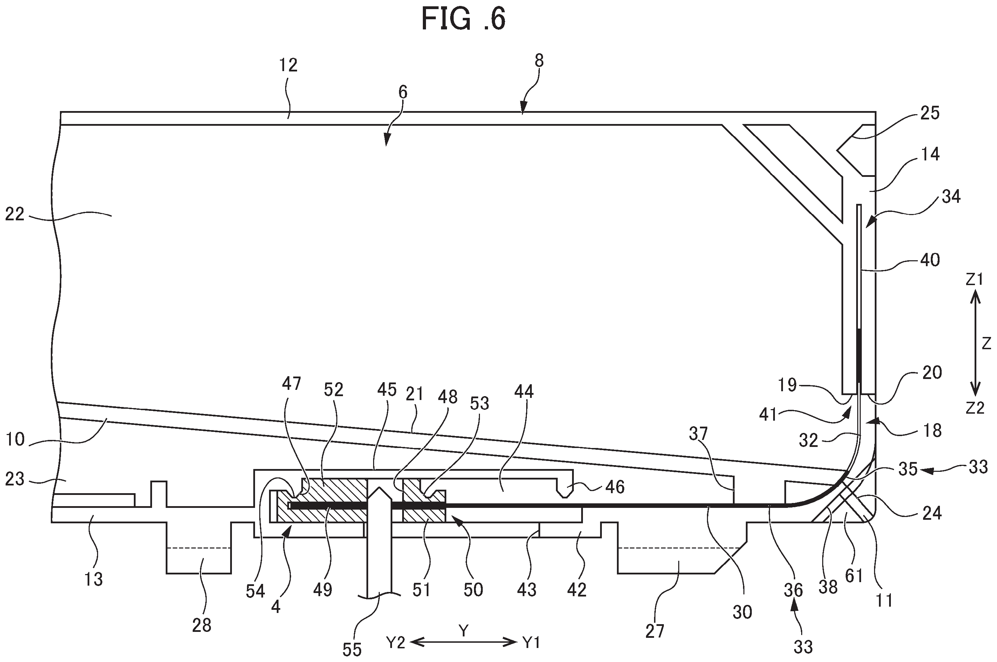

The shutter mechanism 3 enables the component outlet 18 of the case main body 2 to be opened and closed. Typically, the shutter mechanism 3 includes a cover member 30 and a guide portion 31 of the cover member 30. FIG. 5 is a side view showing a portion of the inside of the storage case according to Embodiment 1 of the present invention, and shows a state in which the component outlet of the storage case is closed by the cover member. FIG. 6 is a side view showing a portion of the inside of the storage case according to Embodiment 1 of the present invention, and shows a state in which the component outlet of the storage case is opened.

The cover member 30 opens and closes the component outlet 18 of the case main body 2 by sliding. The cover member 30 is an elongated strip-shaped film member, and extends continuously from the bottom wall portion 13 to the front wall portion 14. The cover member 30 is slidable along the extending direction of the cover member 30. The cover member 30 is made of a material such as PET (polyethylene terephthalate). The material of the cover member 30 is not limited to the PET described above, and it is merely required that the material has a certain degree of rigidity and is a flexible material capable of being curved. The thickness of the cover member 30 including such a film-shaped member is not particularly limited, but is preferably 0.1 mm or more and 0.5 mm or less, for example. The width of the cover member 30 in the left-right direction X is slightly larger than the width of the component outlet 18 in the left-right direction X. Therefore, the cover member 30 is able to cover the component outlet 18 without any gap. As shown in FIG. 1 and FIG. 2, an opening 32 having substantially the same shape as the component outlet 18 is provided at the front end portion of the cover member 30.

The guide portion 31 of the cover member 30 is provided in the case main body 2. The guide portion 31 guides the sliding movement of the cover member 30. In the present Embodiment 1, the guide portion 31 includes a lower guide portion 33 and an upper guide portion 34 provided in the case main body 2. The cover member 30 is slidable along the lower guide portion 33 and the upper guide portion 34. The lower guide portion 33 is provided adjacent to the front side Y1 of the bottom wall portion 13, and the upper guide portion 34 is provided adjacent to the upper side Z1 of the component outlet 18. The cover member 30 slides in a substantially horizontal direction along the lower guide portion 33, and also slides in the upward-downward direction Z along the upper guide portion 34. The lower guide portion 33 and the upper guide portion 34 provide a passage that slidably holds the cover member 30, while maintaining a planar direction of the cover member 30 along the left-right direction X.

The lower guide portion 33 includes a first lower guide portion 35 provided adjacent to the lower side Z2 of the component outlet 18, and a second lower guide portion 36 provided on the rear side Y2 of the first lower guide portion 35. The second lower guide portion 36 is provided by a protrusion 37 provided at the front end portion of the first sloped portion 10 and the bottom wall portion 13. The protrusion 37 has a substantially rectangular block shape, and protrudes from the first sloped portion 10 toward the lower side Z2. A gap along the forward-backward direction Y is provided between the lower surface of the protrusion 37 and the upper surface of the front end portion 38 of the bottom wall portion 13. The first lower guide portion 35 is provided by the front end portion 38 of the bottom wall portion 13, the rear end portion of the second sloped portion 11, and the front end portion of the first sloped portion 10. The front end portion 38 of the bottom wall portion 13 is curved toward the upper side Z1, and is located adjacent to the front side Y1 of the first sloped portion 10. The second sloped portion 11 is provided at the front end portion 38 of the bottom wall portion 13. The second sloped portion 11 extends obliquely toward the lower side Z2 from the front end portion 38 of the bottom wall portion 13. A gap is provided between the rear end portion of the second sloped portion 11 and the front end portion of the first sloped portion 10.

The cover member 30 passes through the gap between the protrusion 37 and the bottom wall portion 13. As a result, the cover member 30 is able to slide in the forward-backward direction Y directly above the bottom wall portion 13 by the second lower guide portion 36. In addition, the cover member 30 slides along the front end portion 38 curved toward the upper side Z1 of the bottom wall portion 13, and also slides through the gap between the front end portion of the first sloped portion 10 and the rear end portion of the second sloped portion 11. As a result, the cover member 30, by way of the first lower guide portion 35, curves toward the upper side Z1 at an angle of approximately 90° from the horizontal direction to be transitioned into a posture extending in the upward-downward direction Z.

As described above, a gap functioning as a passage hole 39 through which the cover member 30 passes is provided between the front end portion of the first sloped portion 10 and the rear end portion of the second sloped portion 11. Therefore, the second sloped portion 11 is not provided continuously with the first sloped portion 10. That is, it can be said that the second sloped surface 24, which is the upper surface of the second sloped portion 11, is provided at the end portion of the first sloped surface 21, which is the upper surface of the first sloped portion 10, via the passage hole 39 through which the cover member 30 passes.

The upper guide portion 34 includes a guide slit 40 provided along the upward-downward direction Z in the front wall portion 14 on the upper side Z1 of the component outlet 18. The guide slit 40 includes an opening portion 41 that opens toward the lower side Z2. The cover member 30 is inserted into the guide slit 40 via the opening portion 41 from the lower side Z2. The cover member 30 is slidable in the upward-downward direction Z along the guide slit 40 in a state of being inserted into the guide slit 40.

As shown in FIGS. 1, 5, and 6, the case main body 2 is provided with the slide member 4 that slides the cover member 30. The slide member 4 is located on the rear side Y2 from the second lower guide portion 36 of the guide portion 31. The slide member 4 is a member that performs an opening and closing operation of the component outlet 18 by sliding the cover member 30.

In order to provide the slide member 4 in the case main body 2, the bottom wall portion 13 of the case main body 2 includes a protruding plate portion 42 extending in the forward-backward direction Y. The protruding plate portion 42 is formed by protruding a portion of the bottom wall portion 13 of the case main body 2 toward the lower side Z2. The protruding plate portion 42 is provided with an elongated hole 43 extending in the forward-backward direction Y. The elongated hole 43 penetrates the protruding plate portion 42 in the upward-downward direction Z. On the upper side Z1 of the protruding plate portion 42, a plate-shaped plate portion 45 is provided such that a predetermined space 44 is provided between the plate portion 45 and the protruding plate portion 42. The plate-shaped plate portion 45 is provided on the upper side Z1 of the protruding plate portion 42 with its plate surface facing the upward-downward direction Z. The plate portion 45 is provided substantially parallel to the protruding plate portion 42. The plate portion 45 is integrally formed with the bottom wall portion 13. Specifically, the plate portion 45 extends toward the upper side Z1 from the bottom wall portion 13, and then extends toward the front side Y1. The space 44 is surrounded by the protruding plate portion 42, the plate portion 45, the left wall portion 16, and the right wall portion 17. The slide member 4 is provided in the space 44 so as to be slidable in the forward-backward direction Y. A front protruding portion 46 is provided at the front end portion of the plate portion 45, and a rear protruding portion 47 is provided at the rear end portion of the plate portion 45. The front protruding portion 46 and the rear protruding portion 47 each protrude toward the lower side Z2 from the plate portion 45.

The slide member 4 is a rectangular plate piece that is long in the forward-backward direction Y. The slide member 4 is provided with an operation hole 48 penetrating in the upward-downward direction Z. As shown in FIG. 3, the operation hole 48 of the present embodiment 1 is an elliptical elongated hole having a major axis along the forward-backward direction Y. The operation hole 48 is not limited to an elliptical shape, and may be, for example, a rectangular shape. The operation hole 48 communicates with the elongated hole 43 of the case main body 2, and is exposed to the outside through the elongated hole 43. In addition, the slide member 4 may have a configuration in which the operation hole 48 is not provided.

A slit 49 extending in the forward-backward direction Y is provided at a substantially middle portion of the slide member 4 in the upward-downward direction Z. The slit 49 opens at least toward the front side Y1 of the slide member 4, and does not open toward the rear side Y2. The slit 49 may open toward the left and right lateral sides X1 and X2 of the slide member 4. The rear end portion of the cover member 30 is inserted into the slit 49. The rear end portion of the cover member 30 is inserted into the slit 49 from the front end opening 50 of the slit 49. The slide member 4 is slidable relative to the cover member 30 in a state in which the cover member 30 is inserted into the slit 49.

The length of the slit 49 in the forward-backward direction Y is preferably approximately 90% of the length of the slide member 4 in the forward-backward direction Y. In that case, the length in the forward-backward direction Y of the thick portion between the rear end of the slit 49 and the rear end surface of the slide member 4 is approximately 10% of the length of the slide member 4 in the forward-backward direction Y. In addition, the length of the slit 49 in the forward-backward direction Y is not limited to this; however, a length is required such that the rear end portion of the sliding cover member 30 is always maintained in a state of being placed in the slit 49.

The slide member 4 includes a first plate-shaped portion 51 provided on the lower side of the slit 49, that is, on the outer side of the slit 49 in the case main body 2, and a second plate-shaped portion 52 provided on the upper side of the slit 49, that is, on the inner side of the slit 49 in the case main body 2. The slide member 4 is integrally formed. The rear end portion of the cover member 30 inserted into the slit 49 is in a state of being provided between the lower (outer) first plate-shaped portion 51 and the upper (inner) second plate-shaped portion 52.

The slide member 4 is provided in the space 44 so as to be movable in the forward-backward direction Y. The forward-backward direction Y here corresponds to the sliding direction of the cover member 30. By being guided by the protruding plate portion 42 of the bottom wall portion 13, the plate portion 45, the left wall portion 16, and the right wall portion 17, the slide member 4 is movable in the forward-backward direction Y relative to the case main body 2. The configuration for guiding the slide member 4 in the forward-backward direction Y is not limited to this. For example, the configuration for guiding the slide member 4 may be a configuration in which flange-shaped plate pieces provided on both left and right lateral surfaces of the slide member are inserted into grooves provided on the inner surface of the left wall portion and the inner surface of the right wall portion, and the slide member is slid in the forward-backward direction Y.

A front recessed portion 53 opening toward the upper side Z1 is provided at the front end portion of the upper surface of the slide member 4, that is, the upper surface of the second plate-shaped portion 52. A rear recessed portion 54 opening toward the upper side Z1 is provided at the rear end portion of the upper surface of the second plate-shaped portion 52. The front recessed portion 53 and the rear recessed portion 54 are groove-shaped recessed portions extending in the left-right direction X.

FIG. 1 shows a state in which the slide member 4 has slid toward the front side Y1 from approximately the middle portion in the forward-backward direction Y within the space 44. When the slide member 4 slides toward the front side Y1, the front end portion of the slide member 4 comes into contact with the front protruding portion 46 of the plate portion 45. When the slide member 4 further slides toward the front side Y1 from this state, the plate portion 45 elastically deforms toward the upper side Z1, so that the front protruding portion 46 rides over the front end portion of the slide member 4, and then enters the front recessed portion 53 of the slide member 4. FIG. 1 shows a state in which the front protruding portion 46 of the plate portion 45 is engaged with the front recessed portion 53 of the slide member 4. By the front protruding portion 46 being engaged with the front recessed portion 53 in this manner, the slide to the front side Y1 of the slide member 4 is restricted.

FIG. 5 shows a state in which the slide member 4 has slid toward the rear side Y2 from approximately the middle portion in the forward-backward direction Y within the space 44. When the slide member 4 slides toward the rear side Y2, the rear end portion of the slide member 4 comes into contact with the rear protruding portion 47 of the plate portion 45. When the slide member 4 further slides toward the rear side Y2 from this state, the plate portion 45 elastically deforms toward the upper side Z1, so that the rear protruding portion 47 rides over the rear end portion of the slide member 4, and then enters the rear recessed portion 54 of the slide member 4. FIG. 5 shows a state in which the rear protruding portion 47 of the plate portion 45 is engaged with the rear recessed portion 54 of the slide member 4. By the rear protruding portion 47 being engaged with the rear recessed portion 54 in this manner, the slide to the rear side Y2 of the slide member 4 is restricted.

When the front protruding portion 46 of the plate portion 45 is engaged with the front recessed portion 53 of the slide member 4, and when the rear protruding portion 47 of the plate portion 45 is engaged with the rear recessed portion 54 of the slide member 4, an operator of the slide member 4 is able to obtain a click feeling. In the following description, the position at which the front protruding portion 46 of the plate portion 45 is engaged with the front recessed portion 53 of the slide member 4 may be referred to as the front end position of the slide member 4, and the position at which the rear protruding portion 47 of the plate portion 45 is engaged with the rear recessed portion 54 of the slide member 4 may be referred to as the rear end position of the slide member 4.

As described above, the rear end portion of the cover member 30 is inserted into the slit 49 of the slide member 4 from the front end opening 50. The slide member 4 is slidable in the forward-backward direction Y relative to the cover member 30 in a state in which the cover member 30 is inserted into the slit 49. That is, the cover member 30 and the slide member 4 are capable of relatively sliding in the forward-backward direction Y, which is the sliding direction of the cover member 30. In other words, the cover member 30 and the slide member 4 are each independently slidable in the forward-backward direction Y in a non-interlocked state with each other. In a state in which the cover member 30 is inserted into the slit 49, the first plate-shaped portion 51 of the slide member 4 is superimposed on the outside of the cover member 30, and the second plate-shaped portion 52 is superimposed on the inside of the cover member 30.

As shown in FIG. 1, the cover member 30 of the storage case 1 is in a state of having slid toward the front side Y1. Specifically, the cover member 30 is located at a closed position in which the component outlet 18 of the case main body 2 is closed. In a state in which the cover member 30 is located at the closed position, the opening 32 of the cover member 30 is located on the upper side Z1 of the component outlet 18. Therefore, the component outlet 18 of the case main body 2 is closed by a lower portion of the cover member 30 relative to the opening 32. In a state in which the cover member 30 closes the component outlet 18, it is possible to reliably close the component outlet 18 by providing a distance between the lower edge of the opening 32 of the cover member 30 and the upper edge of the component outlet 18. More preferably, it is possible to more reliably close the component outlet 18 by setting the distance between the lower edge of the opening 32 of the cover member 30 and the upper edge of the component outlet 18 to 3.9 mm or more. In a state in which the cover member 30 is located at the closed position, a gap is secured between the front end of the cover member 30 and the upper end of the guide slit 40. The length of this gap in the upward-downward direction Z is preferably at least 0.6 mm. By securing a gap between the front end of the cover member 30 and the upper end of the guide slit 40, it is possible to suppress deformation of the cover member 30 resulting from making contact with the case main body 2.

The slide member 4 of the storage case 1 is located at the front end position in a state in which the front protruding portion 46 is engaged with the front recessed portion 53. In a state in which the slide member 4 is located at the front end position, a gap is secured between the rear end of the cover member 30 and the rear end of the slit 49. The length of this gap in the forward-backward direction Y is preferably at least 0.3 mm. By securing a gap between the rear end of the cover member 30 and the rear end of the slit 49, it is possible to suppress deformation of the cover member 30 resulting from making contact with the slide member 4. In a state in which the slide member 4 is located at the front end position, the first plate-shaped portion 51 and the second plate-shaped portion 52 are superimposed on the cover member 30.

As described above, the cover member 30 and the slide member 4 are each independently slidable in the forward-backward direction Y in a non-interlocked state with each other. Here, in a state in which the cover member 30 is located at the closed position, even if the slide member 4 is slid toward the rear side Y2 and placed at the rear end position, the cover member 30 does not slide toward the rear side Y2 together with the slide member 4. Therefore, even if the slide member 4 slides toward the rear side Y2, the state in which the component outlet 18 of the case main body 2 is closed by the cover member 30 is maintained. At this time, the state in which the rear end portion of the cover member 30 has entered the slit 49 is secured. The length in the forward-backward direction Y of the portion of the cover member 30 inserted into the slit 49, that is, the distance between the rear end of the cover member 30 and the front end of the slit 49, is preferably at least 1 mm. By securing the distance between the rear end of the cover member 30 and the front end of the slit 49, it is possible to prevent the cover member 30 from coming off the slide member 4.

When the slide member 4 is slid toward the rear side Y2 together with the cover member 30 from a state in which the cover member 30 is located at the closed position and the slide member 4 is located at the front end position, and then the slide member 4 is slid to the rear end position, the opening 32 of the cover member 30 aligns with the component outlet 18 of the case main body 2. This allows the component outlet 18 of the case main body 2 to be opened. More preferably, when the component outlet 18 is opened, it is possible to reduce deformation of the cover member 30 resulting from making contact with the case main body 2 by securing a gap of approximately 11.6 mm between the front end of the cover member 30 and the upper end of the guide slit 40.

The storage case 1 having the above configuration is capable of opening the cover member 30, for example, as follows. Specifically, as shown in FIG. 6, an operation pin 55 is inserted into the operation hole 48 of the slide member 4 through the elongated hole 43 of the case main body 2, and the operation pin 55 pierces through the cover member 30. As a result, the operation pin 55 is inserted into the operation hole 48 of the slide member 4 in a state of penetrating the cover member 30 in the upward-downward direction Z. From this state, the operation pin 55 is moved in the opening direction of the cover member 30, that is, toward the rear side Y2, along the elongated hole 43 of the case main body 2. As a result, the slide member 4 and the cover member 30 are integrated, so that the slide member 4 and the cover member 30 slide toward the rear side Y2 in an interlocked manner. When the slide member 4 is slid to the rear end position, the opening 32 of the cover member 30 aligns with the component outlet 18 of the case main body 2. As a result, the component outlet 18 of the case main body 2 is opened. In addition, the elongated hole 43 of the case main body 2 has a length that allows the operation pin 55 to slide until the component outlet 18 is opened.

When the cover member 30 is a film member having a thickness of approximately 0.1 mm or more and 0.5 mm or less, the operation pin 55 is able to easily pierce through the cover member 30. The cover member 30 is exposed to the outside through the operation hole 48 of the slide member 4 and the elongated hole 43 of the case main body 2. At this time, since the cover member 30 does not have portions such as holes, protruding portions, or recessed portions that serve as handholds, the flat surface that is the lower surface is exposed to the outside. Therefore, in order to slide the cover member 30, it is necessary to take the trouble of piercing through the cover member 30 with the operation pin 55. By making the cover member 30 difficult to operate in this manner, the storage case 1 has a configuration in which the component outlet 18 cannot be easily opened.

In addition, a through hole through which the operation pin 55 passes may be provided in the cover member 30 in advance. In this case, the operation pin 55 is inserted into the operation hole 48 of the slide member 4 via the elongated hole 43 of the case main body 2, and is also inserted into the through hole of the cover member 30. By operating the operation pin 55 from this state as described above, it is possible to open the component outlet 18 of the case main body 2. By providing the through hole in the cover member 30 in this manner, it is possible to eliminate the trouble of piercing through the cover member 30 with the operation pin 55.

In order to make the cover member 30 difficult to operate, the cross-sectional shape of the operation hole 48 of the slide member 4 may be a complex shape or a special shape. In this case, only an operation pin having a cross-sectional shape corresponding to the cross-sectional shape of the operation hole can be inserted into the operation hole, so it is possible to make the cover member 30 difficult to operate. Examples of the shape of the operation hole that makes the cover member 30 difficult to operate include a cylindrical cross-sectional shape and a star-shaped cross-sectional shape. Furthermore, by adopting a configuration in which the slide member can only be operated with a specially shaped operation pin, it is possible to make the cover member 30 difficult to operate. For example, the slide member can only be operated with a crank-shaped operation pin.

Next, a description will be provided for the operation for discharging the components 5 inside the storage case 1 to the outside. In order to discharge the components 5 inside the storage case 1 to the outside, a feeder that vibrates the storage case 1 is used. The storage case 1 is installed on the feeder via the first claw portion 27, the second claw portion 28, and the third claw portion 29. When installing the storage case 1 on the feeder, protruding portions provided on the feeder engage with the recessed portions 56 provided on the left and right wall portions 16 and 17 of the storage case 1. In a state in which the storage case 1 is installed on the feeder, by vibrating the storage case 1 with the feeder, the components 5 inside the storage case 1 are discharged to the outside of the storage case 1 via the first sloped surface 21 and the second sloped surface 24. When discharging the components 5 inside the storage case 1, the component outlet 18 is opened as described above.

More specifically, the components 5 in the accommodation space 6 slide down the first sloped surface 21 and are carried to the inner opening 19 of the component outlet 18. The components 5 that reach the inner opening 19 of the component outlet 18 slide down the second sloped surface 24 and are carried to the outer opening 20 of the component outlet 18. The components 5 carried to the outer opening 20 of the component outlet 18 are discharged to the outside of the storage case 1 via the outer opening 20. In addition, the method for discharging the components 5 inside the storage case 1 is not limited to the method using a feeder. For example, it is merely required that the component outlet 18 is opened as described above in a state in which the storage case 1 is tilted so that the component outlet 18 opens toward the lower side Z2.

In the configuration of the storage case 1 according to the present embodiment 1, the passage hole 39 through which the cover member 30 passes is provided between the first sloped surface 21 and the second sloped surface 24. When discharging the components 5 inside the storage case 1, the cover member 30 is slid toward the rear side Y2. At this time, the passage hole 39 between the first sloped surface 21 and the second sloped surface 24 is closed by the cover member 30. Therefore, the components 5 will not fall in the passage hole 39 between the first sloped surface 21 and the second sloped surface 24 when discharging the components 5 inside the storage case 1.

In the case of the storage case 1 of the present Embodiment 1, the storage case 1 includes the first sloped surface 21 and the second sloped surface 24. Therefore, according to the storage case 1 of the present Embodiment 1, it is possible to suppress clogging of the components 5 in the component outlet 18 or accumulation of the components 5 that have fallen from the component outlet 18 on the lower side Z2 of the component outlet 18 when discharging the components 5 inside the storage case 1.

In the case of the storage case 1 of the present Embodiment 1, the second sloped surface 24 extends from the inner opening 19 to the outer surface of the outer wall portion 9 of the storage case 1. Therefore, according to the storage case 1 of the present Embodiment 1, it is possible to guide the components 5 discharged from the component outlet 18 further toward the front side Y1, such that it is possible to more reliably suppress the components 5 that have fallen from the component outlet 18 from remaining at the lower side Z2 of the component outlet 18.

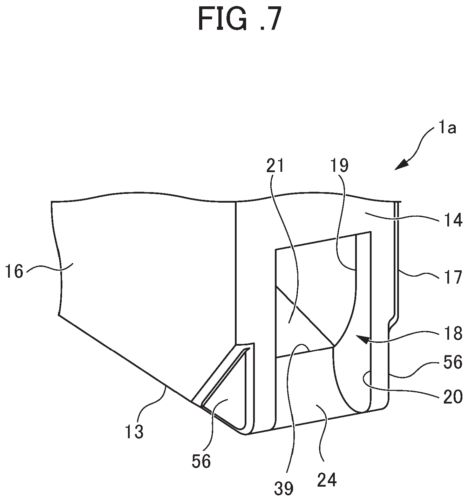

Next, a description will be provided for the storage case 1a of Embodiment 2. In the present Embodiment 2, the characteristic features will be described, and descriptions of matters described in the above Embodiment 1 will be omitted. FIG. 7 is a schematic perspective view showing an enlarged portion of the storage case according to the present Embodiment 2 of the present invention.

The second sloped surface 24 is either planar, curved, or includes a plurality of planes having different slope angles. In the present Embodiment 2, the second sloped surface 24 is curved. Therefore, the second sloped portion 11 is in a curved plate shape. More specifically, the second sloped portion 11 is a plate shape that bulges in an arc shape toward the lower side Z2. Since the second sloped surface 24 corresponds to the upper plate surface of the second sloped portion 11, it is curved in an arc shape that bulges toward the lower side Z2.

The end portion of the second sloped portion 11 adjacent to the inner opening 19 is located at the lower edge portion of the inner opening 19, and the end portion of the second sloped portion 11 adjacent to the outer opening 20 is located at the lower edge portion of the outer opening 20. Therefore, the second sloped surface 24 extends from the lower edge portion of the inner opening 19 toward the lower edge portion of the outer opening 20, while curving so as to bulge toward the lower side Z2. At this time, the second sloped surface 24 extends from the lower edge portion of the inner opening 19 to the outer surface of the outer wall portion 9 of the case main body 2. In the illustrated example, the second sloped surface 24 extends to the outer surface of the corner portion between the front wall portion 14 and the bottom wall portion 13. In the illustrated example, the end portion of the second sloped surface 24 adjacent to the inner opening 19 extends vertically toward the lower side Z2 from the inner opening 19, and the end portion of the second sloped surface 24 adjacent to the outer opening 20 forms an angle of 5° with respect to the horizontal plane.

In the case of the storage case 1a of the present Embodiment 2, the storage case 1a includes the first sloped surface 21 and the curved second sloped surface 24. Therefore, according to the storage case 1a of the present Embodiment 2, it is possible to move the component 5 from the inner opening 19 to the outer opening 20 more quickly.

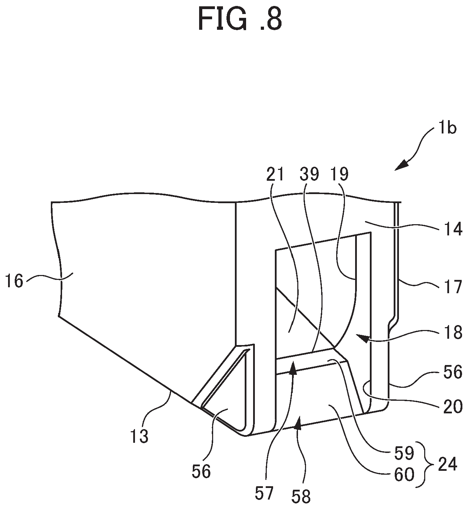

Next, the storage case 1b of Embodiment 3 will be described. The characteristic features Embodiment 3 will be described, and descriptions of matters described in Embodiment 1 above will be omitted. FIG. 8 is a schematic perspective view showing an enlarged portion of the storage case according to Embodiment 3 of the present invention.

The second sloped surface 24 is one of a planar shape, a curved shape, or a shape having a plurality of planes with different slope angles. In the present embodiment 3, the second sloped surface 24 has a plurality of planes with different slope angles. In the illustrated example, the second sloped surface 24 has two planes with different slope angles. Therefore, the second sloped portion 11 includes an inner sloped portion 57 and an outer sloped portion 58.

The inner sloped portion 57 has a substantially rectangular plate shape, and extends in the forward-backward direction Y with its plate surface oriented in the upward-downward direction Z. The inner sloped portion 57 extends from the inner opening 19 toward the outside of the case main body 2. The inner sloped portion 57 is sloped with a downward gradient from the inner opening 19 toward the outside of the case main body 2. In the illustrated example, the inner sloped portion 57 makes an angle of 5° with respect to the horizontal direction. The outer sloped portion 58 has a substantially rectangular plate shape, and extends in the forward-backward direction Y with its plate surface oriented in the upward-downward direction Z. The outer sloped portion 58 extends from the front end portion of the inner sloped portion 57 toward the outside of the case main body 2. The outer sloped portion 58 is sloped with a downward gradient from the front end portion of the inner sloped portion 57 toward the outside of the case main body 2. The outer sloped portion 58 is sloped more steeply than the inner sloped portion 57. In the illustrated example, the outer sloped portion 58 makes an angle of 50° with respect to the horizontal direction. In the present Embodiment 3, it is preferred that the inner sloped portion 57 and the outer sloped portion 58 have different thicknesses. Specifically, the thickness of the inner sloped portion 57 is greater than the thickness of the outer sloped portion 58.

The second sloped surface 24 is the upper plate surface of the second sloped portion 11. Therefore, the second sloped surface 24 includes a planar inner sloped surface 59 that is the upper surface of the inner sloped portion 57, and a planar outer sloped surface 60 that is the upper surface of the outer sloped portion 58. The outer sloped surface 60 is sloped more steeply than the inner sloped surface 59. The length of the outer sloped surface 60 in the forward-backward direction Y is greater than the length of the inner sloped surface 59 in the forward-backward direction Y.

The end portion of the inner sloped portion 57 adjacent to the inner opening 19 is located at the lower edge portion of the inner opening 19, and the end portion of the outer sloped portion 58 adjacent to the outer opening 20 is located at the lower edge portion of the outer opening 20. Therefore, the second sloped surface 24 extends from the lower edge portion of the inner opening 19 toward the lower edge portion of the outer opening 20, while bending so as to protrude toward the upper side Z1. At this time, the second sloped surface 24 extends from the lower edge portion of the inner opening 19 to the outer surface of the outer wall portion 9 of the case main body 2. In the illustrated example, the second sloped surface 24 extends to the outer surface of the corner portion between the front wall portion 14 and the bottom wall portion 13.

As described above, the plate-shaped second sloped portion 11 has two sloped surfaces 59 and 60 with different slope angles, and thus is bent. Therefore, according to the storage case 1b of the present Embodiment 3, it is possible to reduce the space in which the components 5 can exist, and thus it is possible to suppress the accumulation of the components 5 in that space. This makes it possible to discharge the components 5 from the storage case 1b more easily. In addition, it is possible to prevent resin from being unevenly distributed at the corner portion between the front wall portion 14 and the bottom wall portion 13 during molding of the storage case 1b. Furthermore, according to the storage case 1b of the present embodiment 3, it is possible to increase the strength of the corner portion between the front wall portion 14 and the bottom wall portion 13 in the left-right direction X. Here, the second sloped portion 11 has a plate shape. Therefore, a recessed portion 61 provided in the bottom wall portion 13 is located on the rear side Y2 of the second sloped portion 11. The recessed portion 61 has a groove shape opening toward the lower side Z2 and extends in the left-right direction X. When the storage case 1b is provided by injection molding or the like, if resin fills the recessed portion 61, the corner portion between the front wall portion 14 and the bottom wall portion 13 may deform in the cooling step during injection molding. Therefore, the recessed portion 61 is provided in the storage case 1b. This causes the second sloped portion 11 to have a plate shape as described above. When the second sloped portion 11 has a plate shape, the strength of the corner portion between the front wall portion 14 and the bottom wall portion 13 decreases. Therefore, in order to suppress the decrease in strength, the second sloped portion 11 is bent as in the present Embodiment 3. In addition, the inner sloped portion 57 is thicker than the outer sloped portion 58. That is, in the present Embodiment 3, among the two front and rear portions constituting the passage hole 39 through which the cover member 30 passes, the rear end portion of the second sloped portion 11 is provided with a greater thickness. Therefore, according to the storage case 1b of the present Embodiment 3, it is possible to increase the strength of the guide portion 31.

The present invention is not limited to each of the above embodiments, and modifications and improvements within a scope that can achieve the object of the present invention are included in the present invention.

For example, in Embodiment 1, Embodiment 2 and Embodiment 3 described above, the second sloped surface 24 is one of a planar shape, a curved shape bulging toward the lower side Z2, or a shape having two planes with different slope angles, but the present invention is not limited to these. For example, the second sloped surface may have a curved shape bulging toward the upper side Z1, or may have a planar portion and a curved portion. It is merely required that the second sloped surface 24 has a configuration in which it descends toward the lower side Z2 from the first sloped surface 21 and does not rise toward the upper side Z1 or extend horizontally along the way. It is preferred that the end portion of the second sloped surface 24 adjacent to the outer opening 20 is located more than half the distance between the opening end of the inner opening 19 and the opening end of the outer opening 20.

<1> The storage case includes: the case main body 2 including the accommodation space 6 therein capable of accommodating components 5; the component outlet 18 provided in the case main body 2 and including the inner opening 19 that opens to the accommodation space 6 and the outer opening 20 that opens to an outer side of the case main body 2; the first sloped surface 21 provided in the accommodation space 6 and extending toward the inner opening 19; and the second sloped surface 24 extending from the inner opening 19 toward the outer opening 20 in order to guide the components 5 from the inner opening 19 to the outer opening 20.
<2> The storage case includes: the case main body 2 including the accommodation space 6 therein capable of accommodating components 5; the component outlet 18 provided in the case main body 2 and including the inner opening 19 that opens to the accommodation space 6 and the outer opening 20 that opens to an outer side of the case main body 2; the first sloped surface 21 provided in the accommodation space 6 and extending toward the inner opening 19; the shutter mechanism 3 configured to open and close the component outlet 18; and the second sloped surface 24 extending from the inner opening 19 toward the outer opening 20 in order to guide the components 5 from the inner opening 19 to the outer opening 20.
<3> The storage case includes: the case main body 2 including the accommodation space 6 therein capable of accommodating components 5; the component outlet 18 provided in an outer wall portion of the case main body 2, including the inner opening 19 that opens to the accommodation space 6 and the outer opening 20 that opens to an outer side of the case main body 2, and including a lower edge portion of the outer opening 20 located at a lower corner portion of the case main body 2; the first sloped surface 21 provided in the accommodation space 6 and extending toward the inner opening 19; the cover member 30 that opens and closes the component outlet 18 by sliding; the guide portion 31 provided in the case main body 2 and guiding the sliding of the cover member 30; and the second sloped surface 24 extending from a lower edge portion of the inner opening 19 toward the lower edge portion of the outer opening 20 in order to guide the components 5 from the inner opening 19 to the outer opening 20.
<4> In the storage case as described in <1> or <2> above, the second sloped surface 24 extends from the lower edge portion of the inner opening 19.
<5> In the storage case as described in <3> above, the second sloped surface 24 is provided at an end portion of the first sloped surface 21 via the passage hole 39 through which the cover member 30 passes.
<6> In the storage case as described in any one of <1> to <5> above, the second sloped surface 24 is one of a planar shape, a curved shape, or a shape having a plurality of planes with mutually different slope angles.
<7> In the storage case as described in any one of <1> to <5> above, the second sloped surface 24 forms an angle of 40° or more and 90° or less with respect to a horizontal plane.
<8> In the storage case as described in any one of <1> to <7>, the second sloped surface 24 has a surface roughness Ra of 0.5 µm or more and 2.0 µm or less.
<9> In the storage case as described in any one of <1> to <8>, the second sloped surface 24 has a surface resistance value of 10⁹ to 10¹³ Ω/sq.
<10> In the storage case as described in any one of <1> to <9>, the component outlet 18 is provided in the outer wall portion 9 of the case main body 2, the outer opening 20 is provided on an outer surface of the outer wall portion 9, and the second sloped surface 24 extends from the inner opening 19 to the outer surface of the outer wall portion 9.

### EXPLANATION OF REFERENCE NUMERALS

- 1: storage case
- 2: case main body
- 3: shutter mechanism
- 5: component
- 6: accommodation space
- 9: outer wall portion
- 18: component outlet
- 19: inner opening
- 20: outer opening
- 21: first sloped surface
- 24: second sloped surface
- 30: cover member
- 31: guide portion
- 39: passage hole

## Claims

1. A storage case comprising:
a case main body including an accommodation space therein capable of accommodating components;
a component outlet provided in the case main body and including an inner opening that opens to the accommodation space and an outer opening that opens to an outer side of the case main body;
a first sloped surface provided in the accommodation space and extending toward the inner opening; and
a second sloped surface extending from the inner opening toward the outer opening in order to guide the components from the inner opening to the outer opening.

2. A storage case comprising:
a case main body including an accommodation space therein capable of accommodating components;
a component outlet provided in the case main body and including an inner opening that opens to the accommodation space and an outer opening that opens to an outer side of the case main body;
a first sloped surface provided in the accommodation space and extending toward the inner opening;
a shutter mechanism configured to open and close the component outlet; and
a second sloped surface extending from the inner opening toward the outer opening in order to guide the components from the inner opening to the outer opening.

3. A storage case comprising:
a case main body including an accommodation space therein capable of accommodating components;
a component outlet provided in an outer wall portion of the case main body, including an inner opening that opens to the accommodation space and an outer opening that opens to an outer side of the case main body, and including a lower edge portion of the outer opening located at a lower corner portion of the case main body;
a first sloped surface provided in the accommodation space and extending toward the inner opening;
a cover member that opens and closes the component outlet by sliding;
a guide portion provided in the case main body and guiding the sliding of the cover member; and
a second sloped surface extending from a lower edge portion of the inner opening toward the lower edge portion of the outer opening in order to guide the components from the inner opening to the outer opening.

4. The storage case according to claim 1 or 2, wherein the second sloped surface extends from the lower edge portion of the inner opening.

5. The storage case according to claim 3, wherein the second sloped surface is provided at an end portion of the first sloped surface via a passage hole through which the cover member passes.

6. The storage case according to any one of claims 1 to 5, wherein the second sloped surface is one of a planar shape, a curved shape, or a shape having a plurality of planes with mutually different slope angles.

7. The storage case according to any one of claims 1 to 5, wherein the second sloped surface forms an angle of 40° or more and 90° or less with respect to a horizontal plane.

8. The storage case according to any one of claims 1 to 7, wherein the second sloped surface has a surface roughness Ra of 0.5 µm or more and 2.0 µm or less.

9. The storage case according to any one of claims 1 to 8, wherein the second sloped surface has a surface resistance value of 10⁹ to 10¹³ Ω/sq.

10. The storage case according to any one of claims 1 to 9, wherein
the component outlet is provided in the outer wall portion of the case main body,
the outer opening is provided on an outer surface of the outer wall portion, and
the second sloped surface extends from the inner opening to the outer surface of the outer wall portion.
